# EUROPEAN PATENT APPLICATION

(11) **EP 3 736 985 A1**
(43) Date of publication of application: **11.11.2020**
(21) Application number: 19184642.7
(22) Date of filing: 05.07.2019
(51) Int. Cl.: H03K 17/96, H03K 17/94, H03K 17/955

(54) **ILLUMINATED SWITCH**

(30) Priority: 10.05.2019 EP 19173699
(71) Applicant: Captron Electronic GmbH, 82140 Olching (DE)
(72) Inventor: GEBHARD, Roman, 81541 München (DE); ROGGE, Christian, 80337 München (DE)
(74) Representative: Lohr, Jöstingmeier & Partner

(57) **Abstract**

A switch and preferably a sensor switch comprises a capacitive and/or optical sensor for detecting the presence of a body part and a housing defining a mounting plane. The housing further comprises at least one lighting window, covering at least one light source. The at least one light source provides a light beam in a plane parallel to the mounting plane or under an angle directed to the mounting plane.

## Description

### Field of the invention

The invention relates to a switch which is operated by a person or by bringing an object or a body part of a person in close proximity to a sensor or touching said sensor. Such a switch may be a capacitive sensor switch.

### Description of the related art

Switches and specifically capacitively operated sensor switches are often used for operating doors in railways and busses or other public transport systems, or for operating machines. The sensor switches are robust, maintenance-free, easy to use, and can be adapted to many different designs.

Sensor switches are often based on a capacitive sensor technology. A capacitive sensor may detect an approaching object and specifically an approaching body part, which may be a hand or a finger, by capacitively coupling an electrical signal to the object. An approaching object may be detected by an attenuation of the signal voltage or by an increasing signal current flowing through the object.

A switch which may be used for unlocking a door in a public transport is disclosed in US 2005/0231147 A1. Here, the switch is designed as an elongated bar which can easily be recognized due to its size.

A comparatively compact and disk-shaped device is disclosed in DE 197 18 807 C1. Here, a capacitive sensor is mounted to one side of a public transport window. An indicator ring indicating the sensor area of the switch is mounted at the opposing side of the window. The switch is capacitively operated through the window.

### Summary of the invention

The problem to be solved by the invention is to provide a switch with increased visibility. Such a switch may be recognized from a larger distance or under poor lighting conditions.

Solutions of the problem are described in the independent claims. The dependent claims relate to further improvements of the invention.

In an embodiment, a switch comprises a housing comprising a switching element 110 which may be a mechanical switch. In another embodiment, sensor switch comprises a housing comprising a sensor 110 which may include a capacitive and/or optical sensor or which may cover a capacitive and/or optical sensor. Both embodiments may be combined with any of the features described herein.

The housing may further comprise an outer ring. The outer ring further comprises at least one lighting window. Preferably, a plurality of lighting windows are provided. The lighting windows may be symmetrically arranged. For example, if there are two lighting windows, they may be arranged on opposing sides. If there are three lighting windows, these may be arranged under 120 degrees angles. Four lighting windows may be arranged under 90 degrees angles. Behind the at least one lighting window and within the housing is at least one light source which radiates light to the outside of the switch. The light sources may be arranged such that they radiate on a surface on which the switch is mounted. The surface may reflect the light and may provide a marking of the switch and/or a switch appearance which is larger than the switch itself. In addition, any other part of the housing, e.g. the switching element area may emit light. The mitted light may vary in color and intensity and over time.

The at least one lighting window preferably protects the light source from environmental influences and may provide a mechanical and/or electrical shield. It may be a lens or may comprise at least one lens or lens structure, for example a Fresnel-lens or parts thereof.

The housing defines a mounting plane to which the housing (e.g. the switch) may be mounted. Preferably, the switching element has a planar surface which preferably is parallel to the mounting plane.

The housing may be a one piece housing with a preferably threaded shaft for holding the switching element. In another embodiment, the housing comprises a top part and a bottom part which may be mounted distant from each other. The top part may be in electrical and/or optical communication with the bottom part.

In an embodiment, the at least one light source is integrated into the switching element housing. It may also be integrated into an outer ring. In an embodiment, the switching element housing is a two-part embodiment, where the two parts may be mounted at different sides of a window. Here, the switching element and/or sensor electronics may be provided in a first part being on one side of the window, whereas the at least one light source is in another part, which may be an outer ring on the other side of the window. Also a light source for lighting the switching element may be provided. Any of the light sources may be LEDs, OLEDs or other light-emitting devices which are supplied by electrical energy which may be inductively or capacitively coupled from the first part. There may be a coil within the outer ring which is coupled to a coil in the first part to couple the electric energy between the two parts. Alternatively, the light may be emitted by at least one light source which may comprise a LED or other light-emitting components in the first part and guided for example by a lens system through the glass of the window into the second part like an outer ring where it is deflected to the at least one lighting window to the outside of the housing.

The light sources may have different and/or multiple colors which may indicate different states of the switch or different types or kinds of switches.

### Description of Drawings

In the following the invention will be described by way of example, without limitation of the general inventive concept, on examples of embodiment with reference to the drawings.
Figure 1 shows a top view of an embodiment.
Figure 2 shows a perspective view of an embodiment.
Figure 3 shows an embodiment mounted into a window.
Figure 4 shows a two-part embodiment.
Figure 5 shows an exemplary light distribution in a top view.
Figure 6 shows an exemplary light beam of the switch.

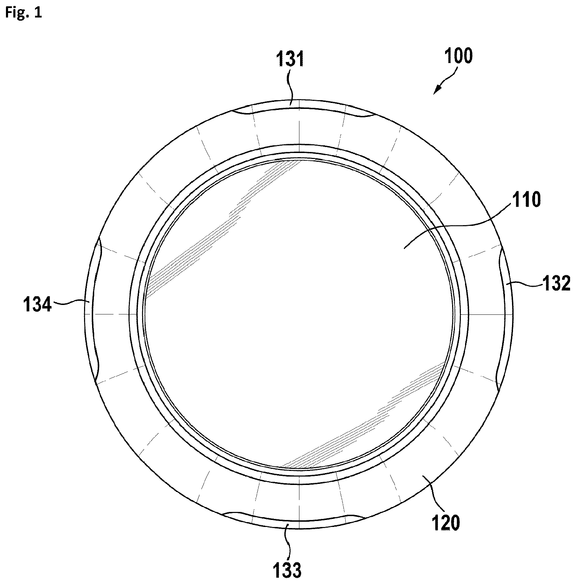

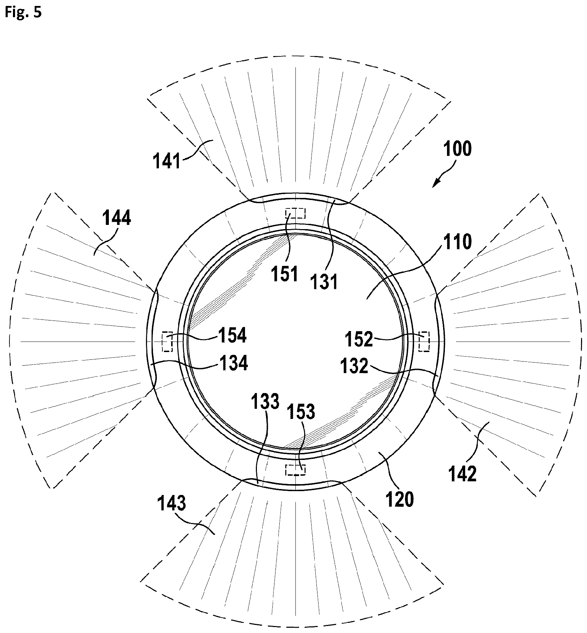

In Figure 1, a top view of an embodiment is shown. A switch 100 comprises a preferably planar switching element 110 or a planar sensor which is sensitive to an approaching object which may be a hand or a finger of a person. Preferably, the switching element 110 is a mechanical or electronic switching device or a a capacitive and/or optical proximity sensor. The switching element preferably has a planar surface. There may be an outer ring 120 surrounding the switching element 110. A plurality of lighting windows 131, 132, 133, 134 are provided circumferentially to the switching element and may be integrated into the outer ring 120. Preferably, the lighting windows are arranged symmetrically. In the embodiment shown herein, four lighting windows are provided which are arranged under angles of 90 degrees between adjacent windows. The windows have an elongated shape but they may have any other shape, like a circular shape or a rectangular slot, or any other shape which is suitable for providing a light output. Preferably, the lighting windows comprise a material which may conduct light of a suitable wavelength. Not shown in this Figure (but in Fig. 5) are light sources 151 - 154 which provide light which exits through the lighting windows. Preferably, at least one light source is provided within the switch and behind each of the lighting windows.

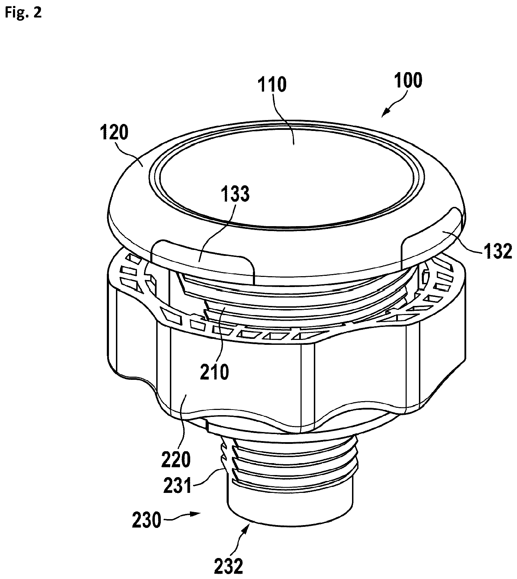

In Figure 2, a perspective view of an embodiment is shown. In addition to the top of the switch, the bottom components are also shown. There may be a shaft 210 which may comprise switching mechanics or electronics or further electronic devices required for capacitive and/or optical detection of an object in close proximity to the sensor 110. The shaft may have an outer thread which matches to a fastening nut 220. At the housing, there may also be a signal connector 230 for electrical connections providing power to the switch and coupling of a detection signal. The connector may have an outer thread 231 and connecting pins 232 which are on the bottom side in this embodiment and cannot be seen.

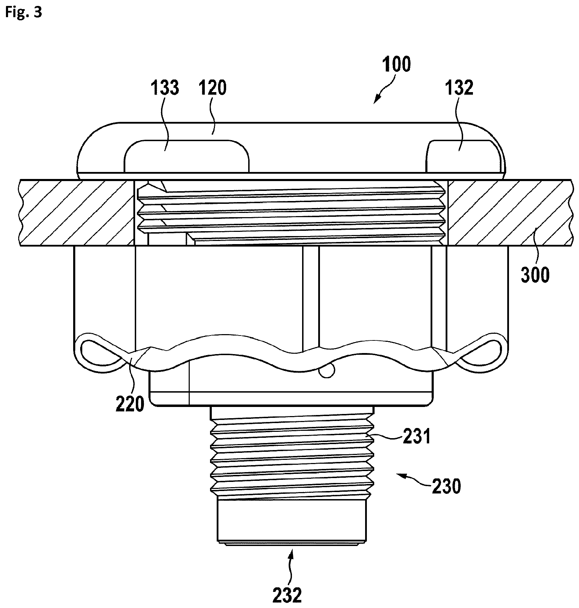

In Figure 3, an embodiment is shown, which is mounted into a plate 300 which may be a window or a glass plate. It may also be a window comprising multiple parallel glass plates. The fastening nut 220 may be rotated to hold the switch within a hole of the window. The mounting plane is the top plane of the plate 300, which preferably corresponds to an under side of the top part of the housing containing the switching element.

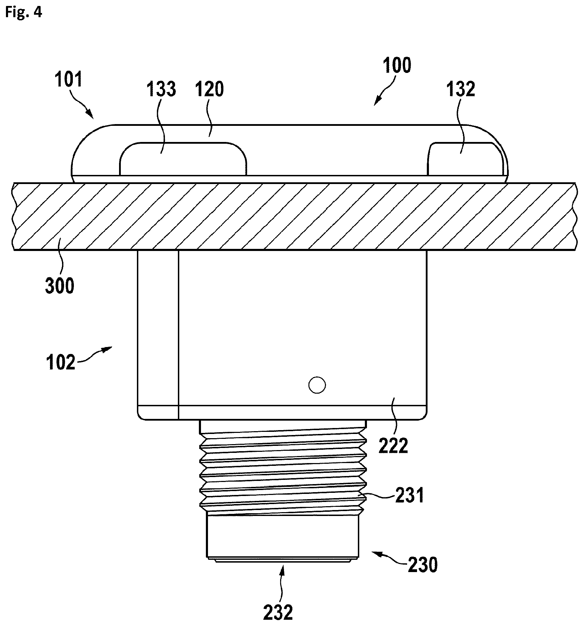

In Figure 4, a two-part embodiment is shown. Here, the switch 100 comprises a top part 101 which is attached on one side of the plate 300, which may be a window, and a bottom part 102 which is mounted opposing to the top part 101 on the other side of the plate 300, which may be a window. The advantage of this embodiment is that there is no hole required in the window. The disadvantage is that coupling of electrical signals and/or sensing of an object may be somewhat more complicated due to the higher coupling distance through the plate, which may be a window, and coupling of light or electrical power for light sources from the second part 102 to the first part 101 may require additional effort as disclosed above. The mounting plane is the top plane of the plate 300, which preferably corresponds to an under side of the top component 101.

In Figure 5, an exemplary light distribution of the switch is shown in a top view. In addition, here only for demonstration purposes, the light sources 151, 152, 153, 154 are indicated. They cannot be seen, as they are embedded into the outer ring 120 of the switch. The light sources radiate light through the lighting windows 131, 132, 133, 134 and generate light beams 141, 142, 143, 144. These light beams are preferably directed under a small angle to the surface on which the switch is mounted, as will be shown in the next Figure.

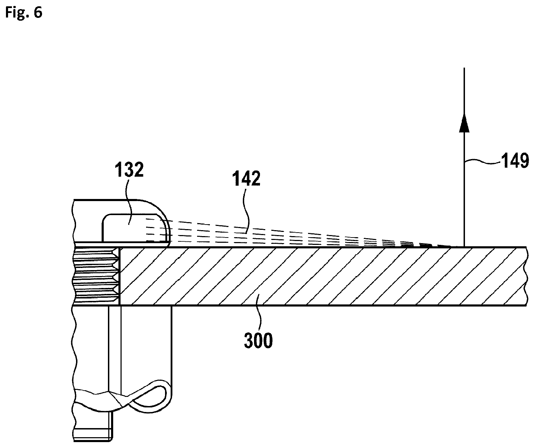

In Figure 6, an exemplary light beam of the switch is shown. Here, light emitted through the lighting window 132 forming a light beam 142 is directed under a small angle towards the plate 300 which may be a window or a metal plate. The light is reflected by the plate 300 and may be seen by a person, such as a person operating the switch. The best results are provided if the surface of the plate is light reflecting such that the light emitted through the window 132 is emitted in a direction orthogonal to the plate, such as indicated by arrow 149.

### List of reference numerals

- 100: switch
- 101: top part of housing
- 102: bottom part of housing
- 110: switching element
- 120: outer ring
- 131-134: lighting windows
- 141-144: light beams
- 149: direction of reflected light
- 151 - 154: light sources
- 210: shaft
- 220: fastening nut
- 230: signal connector
- 231: outer thread
- 232: connecting pins
- 300: mounting plate

## Claims

1. A switch (100) comprising a switching element (110),
**characterized in, that**
the switch (100) comprises a housing (101, 102, 210), defining a mounting plane and further comprising at least one lighting window (131 - 134), the at least one lighting window (131 - 134) covering at least one light source (151 - 154) in the housing providing a light beam (141 - 144) in a plane parallel to the mounting plane or under an angle directed to the mounting plane.

2. A switch (100) according to claim 1,
**characterized in, that**
the switch comprises a one-piece housing including a switching element (110) and a shaft (210).

3. A switch (100) according to claim 2,
**characterized in, that**
the shaft (210) has an outer thread (231).

4. A switch (100) according to claim 1,
**characterized in, that**
the switch comprises a housing comprising a top part (101) and a bottom part (102) which may be mounted distant from each other.

5. A switch (100) according to claim 4,
**characterized in, that**
the top part (101) is in electrical and/or optical communication with the bottom part (102).

6. A switch (100) according to any of the previous claims,
**characterized in, that**
the switching element (110) comprises a light source for lighting the switching element (110).

7. A switch (100) according to any of the previous claims,
**characterized in, that**
at least one light source is a LED, a OLED.

8. A switch (100) according to any of the previous claims,
**characterized in, that**
the switch (100) is a sensor switch and wherein the switching element is a capacitive and/or optical sensor (110) for detecting the presence of a body part.
